# DEMANDE DE BREVET EUROPEEN

(11) **EP 0 858 257 A2**
(43) Date de publication de la demande: **12.08.1998**
(21) Numéro de dépôt: 98500030.6
(22) Date de dépôt: 04.02.1998
(51) Int. Cl.: H05K 13/04

(54) **Contre-bouterolle perfectionnée**

(30) Priorité: 06.02.1997 ES 9700234
(71) Demandeur: MECANISMOS AUXILIARES INDUSTRIALES S.A. M.A.I.S.A., E-43800 Valls, Tarragona (ES); Construcciones Mecanicas Jose Lazpiur, S.A., 43800 Valls, Tarragona (ES)
(72) Inventeur: Altes Puig, Josep, 43800 Valls (Tarragona) (ES); Lazpiur Lamariano, Miguel, 43800 Valls(Tarragona) (ES)
(74) Mandataire: Morgades Manonelles, Juan Antonio

(57) **Abrégé**

La présente invention a pour objet de perfectionner le système de travail de la contre-bouterolle, de sorte que celle-ci ne soit pas affectée par la présence des particules susmentionnées, ce qui s'obtient en modifiant la configuration du poinçon et en introduisant des moyens de nettoyage dans la partie supérieure de la contre-bouterolle, ainsi les éventuelles parties ou particules introduites par cette conduite sont rejetées et retirées de celle-ci, le poinçon n'étant dès lors affecté par aucune des actions précédemment citées.

## Description

La présente sollicitude de patente d'invention consiste, conformément aux indications de l'énoncé, en une "CONTRE-BOUTEROLLE PERFECTIONNÉE", dont les nouvelles caractéristiques de construction, conformation et conception remplissent la mission pour laquelle elle a été spécifiquement projetée, avec un maximum de sécurité et d'efficacité.

Il existe sur le marché, et elles peuvent donc être considérées comme un état de la technique, des contre-bouterolles qui consistent en général en une pièce en fer avec un trou ou cavité au milieu que les forgerons d'antan plaçaient sous la pièce qu'ils souhaitaient pénétrer avec le poinçon pour que celui-ci ne s'ébrèche pas contre la bigorne. Dans le cadre de ce concept générique et par assimilation à d'autres domaines, on appelle contre-bouterolle un dispositif qui fonctionne comme tel et qui s'applique dans d'autres secteurs techniques à ceux de la fabrication de machines à insérer pour circuit imprimé.

Sur ce type de machines, c'est-à-dire les machines à insérer le circuit imprimé, il existe une tête d'insertion qui, par les moyens appropriés, de préférence des signaux reçus par un ordinateur conventionnel, agit sur le circuit imprimé conventionnel, en insérant sur celui-ci des douilles, des fiches, des languettes et tout autre type d'éléments électriques et électroniques. Lors de l'opération d'insertion, la tête, en agissant comme telle, exerce une pression considérable sur le corps ou la base de ce circuit imprimé, motif pour lequel pour éviter que celui-ci ne soit endommagé sur le point concret où est inséré le composant électrique ou électronique, combinant l'action de la tête d'insertion avec une contre-bouterolle, laquelle reçoit à son tour les ordres correspondants du même ordinateur conventionnel pour se placer sur le même point sur lequel cette tête posera lesdits composants électriques et électroniques afin d'éviter ainsi l'éventuelle déformation par la propre fonction d'insertion.

Les contre-bouterolles appliquées sur ce type de machines à insérer consistent essentiellement en une tête, de préférence cylindrique, dont la partie centrale dispose d'une conduite et par l'intérieur de laquelle coulisse, par les moyens appropriés, une sorte de poinçon qui, lui, pénètre dans le point adéquat du circuit imprimé situé dans la zone de travail de la table de coordonnées correspondantes et s'en retire lorsque la tête d'insertion a effectué sa fonction.

L'action ascendante et descendante du poinçon par l'intérieur de la conduite centrale de la tête de la contre-bouterolle est effectuée à l'aide d'une came conventionnelle, laquelle est actionnée hydrauliquement ou pneumatiquement par le biais d'un détecteur dont la fonction est de communiquer à cette came lorsqu'elle doit monter ou descendre et agir sur la tête du poinçon pour que celui-ci sorte de la partie supérieure de la tête de la contre-bouterolle et joue son rôle de soutien de la tête d'insertion située dans la partie supérieure du circuit imprimé.

Les problèmes que présente ce type de contre-bouterolles sont, outre celui de la résistance du poinçon lui-même qui se trouve à l'intérieur, le coup du dispositif d'insertion sur le circuit imprimé, et la chute sur ce poinçon de petites particules qui, lors de l'opération d'insertion des douilles, languettes, fiches, ponts et tout autre type de composants, sont arrachées ou griffées le corps du circuit imprimé, une partie de celles-ci tombent dans la conduite à l'intérieur de laquelle le poinçon de la contre-bouterolle monte et descend, c'est pour cela que cette poussière ou ces particules finissent par éroder la surface latérale du poinçon et en provoquent l'usure prématurée ou finissent par empêcher celui-ci de monter à l'intérieur de la conduite. Dans d'autres situations, la présence de ces particules ou copeaux provenant soit des éléments qui sont insérés, soit du corps du propre circuit imprimé, finissent par ralentir le mouvement ascendant et descendant de sorte que le poinçon ne se trouve pas avec la contre-bouterolle sur le point approprié au moment indiqué ; ainsi, l'effet de la contre-bouterolle est entièrement absorbé par le circuit imprimé, celui-ci étant endommagé et devant être jeté avec les pertes économiques correspondantes.

Un autre problème supplémentaire est la nécessité que cette tête puisse couvrir trois courses distinctes, une normale jusqu'au plan supérieur de la couche conductrice en cuivre du circuit imprimé et une seconde course qui couvre les zones sur lesquelles la tête arrive sur trois points où il n'y a pas de couche conductrice de cuivre et une troisième pour retirer le circuit du plateau situé sur la table de coordonnées, pour cela ladite contre-bouterolle nécessite deux cylindres pneumatiques.

La présente invention a pour objet de perfectionner le système de travail de la contre-bouterolle, de sorte que celle-ci ne soit pas affectée par la présence des particules susmentionnées, ce qui s'obtient en modifiant la configuration du poinçon et en introduisant des moyens de nettoyage dans la partie supérieure de la contre-bouterolle, ainsi les éventuelles parties ou particules introduites par cette conduite sont rejetées et retirées de celle-ci, le poinçon n'étant dès lors affecté par aucune des actions précédemment citées.

D'autres détails et caractéristiques de l'actuelle patente d'invention seront soulignés au cours de la description qui est donnée ci-dessous, et qui fait référence aux figures accompagnant ce mémoire dans lequel, de façon quelque peu schématique, sont représentés les détails préférés. Ces détails sont donnés à titre d'exemple et se réfèrent à un cas possible de réalisation pratique, mais ne demeurent pas limités aux détails qui y sont exposés ; cette description doit donc être considérée d'un point de vue illustratif et sans aucune sorte de limitations.

Nous établirons ci-dessous une liste détaillée des divers éléments cités dans la présente sollicitude de patente d'invention : (10) contre-bouterolle, (11) base de la contre-bouterolle (10), (12) corps de (10), (12a) conduite, (13) poinçon, (13a) partie supérieure de (13), (13b) partie inférieure de (13), (14) tête, (15) support de la contre-bouterolle, (16) banc, (17) tête, (18) vis, (19) came, (20) goupille, (21) détecteur, (22) table de coordonnées, (23) support détecteur, (24) vis, (25) prisonnier, (26) ressort, (27) soufflante, (28) support de soufflante, (29) partie tronconique, (30) trous, (31) circuit imprimé, (32) conduites d'évacuation, (33) cylindre pneumatique, (34) douille, (35) embouchure, (36) goupille.

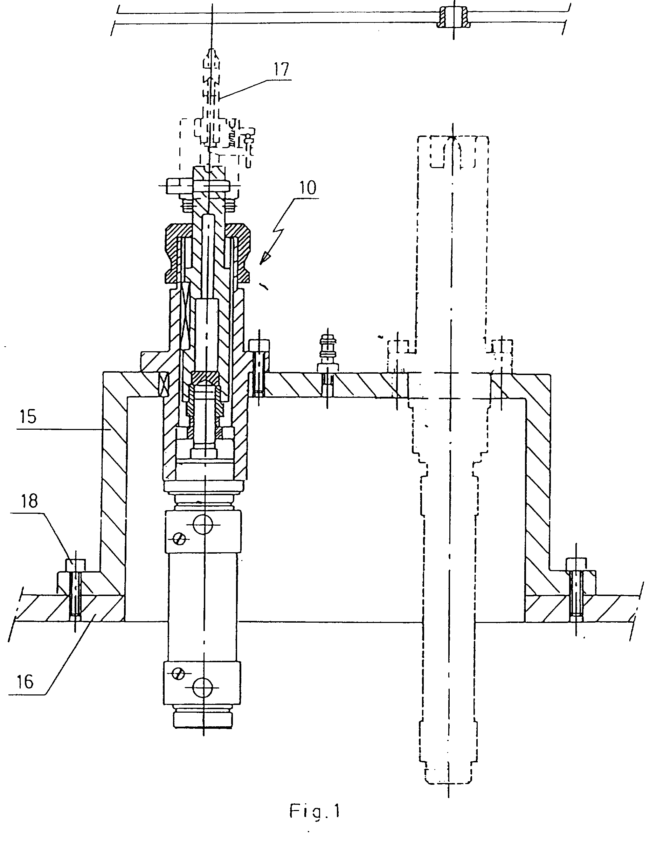

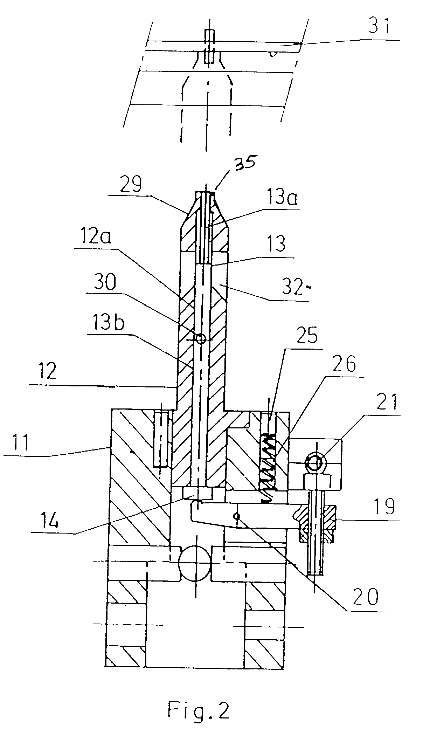

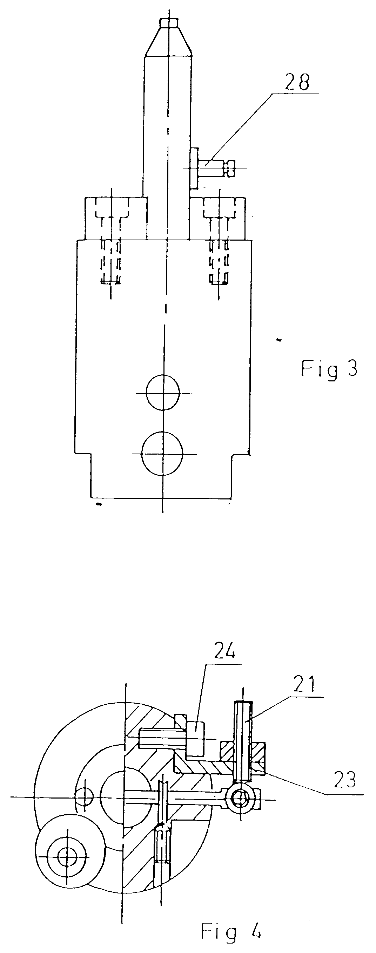

La figure nº 1 est une section longitudinale en élévation d'une contre-bouterolle (10) et d'un cylindre (33) qui, au moyen de sa tige (34), agit sur la table de coordonnées (22) par le biais d'une douille (30), montés par les moyens appropriés sur un support (15), lui-même immobilisé à l'aide des vis correspondantes (18) au banc (16) d'une machine à insérer conventionnelle.

La figure nº 2 est une section longitudinale en élévation partielle de la contre-bouterolle (10) qui ne comprend que la partie supérieure de celle-ci, également dénommée de pointe.

La figure nº 3 est une vue schématisée de la partie supérieure de la contre-bouterolle (10) selon la figure nº 2, sur laquelle on peut voir comment sur le corps (12) de la contre-bouterolle (10) l'on a prévu un support (28) pour une soufflante conventionnelle qui n'est pas représentée sur la figure.

La figure nº 4 est une section partielle, selon la figure nº 2, du corps (12) de la contre-bouterolle (10). Dans l'une des réalisations préférées, et selon ce qui est considéré comme étant l'état de la technique, sur les machines à insérer conventionnelles et dans la partie inférieure de celle qui correspond à sa table de coordonnées (22) sont situées les contre-bouterolles (10), qui sont elles-mêmes montées, par les moyens appropriés, à un support (15) qui est immobilisé au banc (16) de cette machine à insérer à l'aide de vis (18), voir la figure nº 1.

Les perfectionnements faisant l'objet de la présente sollicitude sont uniquement et exclusivement centrés sur le fait qu'il convient de considérer comme partie supérieure de la contre-bouterolle (10) qui est représentée sur la figure nº 2 et sur laquelle on peut voir une base (11) qui se solidarise par les moyens appropriés à (10) et dont le corps (12) présente, comme il est déjà notoire, une configuration cylindrique et dont la partie supérieure s'achève sur une partie tronconique (29) qui sert de base à cette bouche (35). Le corps (12) de la contre-bouterolle (10) présente une conduite intérieure (12a) par laquelle le poinçon (13) se déplace alternativement et en sens vertical. La pointe ou partie supérieure (12) de la contre-bouterolle peut être facilement changée au travers de la goupille (36), ce qui fait que les possibilités de travail de la contre-bouterolle (10) s'en trouvent multipliées, permettant en fonction des courses (trois) du poinçon et pouvant s'adapter à tous types de circuits imprimés (31) et à différentes douilles, fiches terminales et similaires.

Le poinçon (13), d'une configuration sensiblement cylindrique, a été modifié de sorte que sa partie supérieure (13a) présente un diamètre inférieur à celui de la partie inférieure (13b) ; de même, le corps (12) de la contre-bouterolle (10) présente des trous (30) servant à l'entrée d'air d'une soufflante (27) conventionnelle montée sur un support (28), voir la figure nº 3 ; l'essence de l'invention réside dans la combinaison du changement de diamètre du poinçon (13) de la zone supérieure (13a) par rapport à l'inférieure (13b), avec la prévision dans la conduite (12a) des vis (30) servant à l'entrée d'air provenant d'une soufflante (27) qui n'est pas représentée sur les figures et qui est accouplée au corps (12) de la contre-bouterolle (10), voir la figure nº 3.

Comme il est notoire, le poinçon (13) est doté d'un mouvement vertical ascendant et descendant, car l'on a prévu sur sa tête (14) une came (19) qui se déplace autour d'une goupille (20), laquelle entre en mouvement par l'action d'un détecteur (21) qui lui-même ordonne la longueur de la course que doit effectuer le poinçon (13), en fonction du circuit imprimé (31) sur lequel il doit agir, (21) étant placé dans les environs immédiats, de sorte que, à l'aide d'un prisonnier (25) et un ressort (26) logés sur la base (11) de la contre-bouterolle (10), la came (19) permet d'osciller de haut en bas et communiquer ainsi le mouvement vertical ascendant et descendant au poinçon (13), qui est lui-même libéré des particules qui se déposent sur les surfaces latérales de (13a) et (13b) et qui pourraient entrer par la partie supérieure tronconique (29) et l'embouchure (35) une partie (13a) du poinçon ayant été prévue avec un diamètre inférieur, ce qui fait que l'air provenant de la soufflante (27) entre par les trous (30) et nettoie la surface latérale cylindrique de cette partie (13a) et (13b) du poinçon (13), évitant ainsi la présence et l'accumulation de particules ou copeaux provenant du circuit imprimé (31) situé dans la zone de travail, la table de coordonnées (22), qui n'est pas représentée sur la figure, logeant ce circuit imprimé (31).

La différence de diamètres entre le diamètre de la conduite (12a) et de la partie supérieure (13a) de (13) forme une chambre cylindrique qui est battue par l'air provenant de la soufflante (27) et évacué au travers des conduites (32), voir la figure nº 2.

Avec la disposition précédente, sans altérer la plupart des pièces de la contre-bouterolle (10), pouvant être considérées comme connues, l'on obtient de notables bénéfices qui se matérialisent par une régularité du mouvement du poinçon (13) durant sa vie utile ; d'autre part, la vitesse du mouvement de ce poinçon (13) demeure également invariable durant la vie de ce poinçon, ce qui fait que l'on évite, comme cela a déjà été commenté, que, même si la came (19) reçoit les ordres correspondants du détecteur (21) en ce qui concerne la longueur de la course à exécuter, le poinçon (13) parvienne au circuit imprimé (31) retardé au moment même où la tête d'insertion pose un composant électrique ou électronique au-dessus dudit circuit imprimé (31).

La présente patente d'invention ayant été suffisamment décrite en correspondance avec les plans ci-joints, il est entendu que toutes modifications de détail jugées opportunes pourront être introduites sur ceux-ci, à la condition de ne pas altérer l'essence de la patente qui se trouve résumé dans les REVENDICATIONS suivantes.

## Revendications

1. "CONTRE-BOUTEROLLE PERFECTIONNÉE" de celles qui sont formées dans leur partie supérieure par un corps cylindrique doté de moyens d'entraînement pneumatiques ou hydrauliques qui agissent sur une came (19) avec un axe de giration sur une goupille (20), cette came (19) agissant sur la tête (14) du poinçon (13) d'une contre-bouterolle (10) lorsque la came (19) reçoit l'ordre au travers du détecteur (21) pour impulser ce poinçon (13) vers le haut ou vers le bas ; caractérisée par le fait que sur le corps (10) qui émerge de la base (11) de la contre-bouterolle (10) l'on a prévu une conduite intérieure à (12) cylindrique par l'intérieur de laquelle se déplace verticalement de haut en bas un poinçon (13) dont la partie supérieure (13a) présente un diamètre inférieur à celui de la partie inférieure de (13), (13b) expulsant les particules introduites dans la zone et partie tronconique (29) et l'embouchure (35) provenant du circuit imprimé (31) par de l'air sous pression, introduit par une soufflante montée sur un support (28) au corps (12) de la contre-bouterolle (10).

2. "CONTRE-BOUTEROLLE PERFECTIONNÉE" caractérisé selon la 1ère revendication par le fait que, sur le corps (12) de la contre-bouterolle (10), on a prévu des trous (30) dans lesquels est accouplée une soufflante (27) par le biais d'un support (28) qui, aux moments programmés, soumet la chambre formée entre les parois (13a) et (13a) à un balayage d'air sous pression expulsé dans des conduites d'évacuation (32) situées à une hauteur supérieure des trous (30).

3. "CONTRE-BOUTEROLLE PERFECTIONNÉE" caractérisée selon la 1ère revendication par le fait que le poinçon (13) offre la possibilité d'exécuter trois courses distinctes à l'intérieur de la conduite (12a) verticale située en position centrale dans le centre du corps (12) de la contre-bouterolle (10) en fonction des ordres reçus du détecteur (21).

4. "CONTRE-BOUTEROLLE PERFECTIONNÉE" caractérisée selon la 1ère revendication par le fait que la pointe ou partie supérieure (12) de la contre-bouterolle est interchangeable à l'aide d'une goupille (36) située sur la base (11) de (10).
